# EUROPEAN PATENT APPLICATION

(11) **EP 4 177 217 A1**
(43) Date of publication of application: **10.05.2023**
(21) Application number: 21206693.0
(22) Date of filing: 05.11.2021
(51) Int. Cl.: B81C 1/00

(54) **FABRICATION METHOD OF MEMS TRANSDUCER ELEMENT**

(71) Applicant: TE Connectivity Solutions GmbH, 8200 Schaffhausen (CH)
(72) Inventor: Le Neal, Jean-Francois, Bevaix (CH); Jenni, Kaspar, Bevaix (CH)
(74) Representative: Grünecker Patent- und Rechtsanwälte PartG mbB

(57) **Abstract**

The invention relates to a method of fabricating a plurality of individual microelectromechanical transducer elements (MEMS) comprising the steps of a) realizing a plurality of microelectromechanical transducer elements on a wafer (200), wherein each transducer element comprises a sensitive region (204) with a membrane (208) and one or more sensing elements (210a, 210b) for monitoring at least one measurand and generating an electrical signal correlated with the at least one measurand, and one or more electrical contacts (206a, 206b) for outputting the electrical signal, b) providing, for each microelectromechanical transducer element a sealing structure (222) around its sensitive region (204) and one or more electrical connections (224a, 224b) each connected to a respective one of the one or more electrical contacts (206a, 206b), wherein the sealing structure (222) and the electrical connections (224a, 224b) are made out of the same material, in particular a solder material, more in particular a reflow solder material, and then c) dicing the wafer (200) to form individual microelectromechanical transducer elements. The invention also relates to a microelectromechanical transducer element and to a MEMs sensor arrangement.

## Description

The present invention relates to a method of fabricating a plurality of microelectromechanical (MEMS) transducer element and a microelectromechanical (MEMS) sensor arrangement as well as to a micromechanical (MEMs) transducer element for monitoring at least one measurand and for generating an electrical output signal correlated with the at least one measurand.

MEMs sensor arrangements are known in the art and comprise a transducer element for monitoring at least one measurand and generating an electrical output signal correlated with the at least one measurand. The medium, which is to be monitored, has to gain access to defined sensitive elements of the sensor arrangement while it has to be ensured that a potentially aggressive and/or humid environment does not damage and/or impair the remaining parts. This is in particular true for electronic components of the sensor arrangement.

Furthermore, component suppliers provide sensor components in a not yet fully assembled state to the original equipment manufacturers (OEM). Thus, providing a sealing that protects the electronic components has to be facilitated. This sealing should allow for an automated assembly procedure performed outside the premises of the component supplier.

Such a MEMS sensor arrangement is known from EP 3 456 682 A1. A side cut view of the sensor arrangement 100 is shown in Figure 1. The sensor arrangement 100 comprises a ceramic sensor 102 with a transducer element 104 mount onto a substrate 106. A channel 108 is provided in the substrate 106. The medium to be monitored enters through the channel 108 to impinge onto the transducer element 104. The ceramic sensor 102 further comprises a transducer substrate 110 and side wall electrodes 112. Using contact pads 114, the electrodes 112 are connected to electrical leads 116 that are provided on the surface of the substrate 106 to electrically connect the transducer element 104 to further electrical components 118 of the sensor arrangement 100.

A solder seal 120 is provided between the transducer element 104 and the substrate 106 around the media channel 108 to seal and protect the electrical components 118, the electrical leads 116, the contact pads 114 and the electrodes 112 from the media channel 108.

In addition, a protective cover 122 made from plastics, ceramic, glass or from an electrically conductive material, is provided to protect the transducer element 102.

Typically, the ceramic sensor 102 is fabricated by the sensor manufacturer which also provides a first level packaging and sealing of the sensor and it is then delivered to an OEM who takes care of the electrical connections and pressure port sealing. The sensor sealing and its connectivity to the electrical components 118 is still challenging, as it is time consuming and quality control still tedious.

It is therefore an object of the invention to simplify the integration process of MEMs based sensor arrangements.

The object of the invention is achieved with a method of fabricating a plurality of individual microelectromechanical (MEMS) transducer elements, said method comprising the steps of a) realising a plurality of microelectromechanical transducer elements on a wafer, wherein each transducer element comprises a sensitive region with a membrane and one or more sensing elements, e.g. one or more strain gauges and/or capacitive structures, for monitoring at least one measurand and generating an electrical output signal correlated with the at least one measurand, and one or more electrical contacts for outputting the electrical signal, b) providing, for each microelectromechanical transducer element a sealing structure around its sensitive region and one or more electrical connections each connected to a respective one of the one or more electrical contacts, wherein the sealing structure and the electrical connections are made out of the same material, in particular a solder material, more in particular a reflow solder material, and then a step c) of dicing the wafer to form individual microelectromechanical (MEMs) transducer elements.

Thus, the step b) of providing a sealing structure and an electrical connection structure on a transducer element at the transducer substrate level is performed on wafer level at the OEM fabrication site and can be provided for realized for all transducer elements of the wafer at the same time. When integrating the transducer into a complete sensor arrangement, the electrical connection and the sealing can be realized in one step without the need of applying individual sealing and connecting structures on packaging level.

According to a variant of the invention, during step b), the sealing structure and the electrical connections can be realized during the same process steps. As a result, the process is less complex and can be realized faster since only one step is required for providing both the sealing structure and the electrical connections for the plurality of transducer elements on the wafer.

According to a variant of the invention, step b) can comprise providing the sealing structure and the electrical connections over the same surface side of the wafer. This further simplifies the process.

According to a variant of the invention, the step b) can comprise providing the sealing structure and the electrical connection structure over opposite sides of the wafer. In this variant, the electrical contacts can be arranged further away from the potentially aggressive and/or humid environment provided by the measurand entering the device.

According to a variant of the invention, the method can further comprise a step of providing at least one via per transducer element through the wafer. By providing vias, electrical connections can be moved to the side of the wafer opposite to where sealing will occur in later process steps.

According to a variant of the invention, the method can further comprise before step c): a step of providing a substrate, comprising a plurality of channels extending through the substrate, a step of aligning each channel with a corresponding sensitive region of a microelectromechanical transducer element, and a step of attaching the substrate to the wafer using the sealing structure and the electrical connections to thereby seal the interface between the sensitive region of the transducer element and the substrate from the remaining region of the transducer element and to electrically connect the one or more electrical contacts of the transducer element with mating electrical contacts of the substrate . Thus, still on wafer level and in one process step, the sensitive regions of the microelectromechanical transducer elements can be assembled with a media channel provided on the mating substrate. Thereby, the fabrication process of a plurality of devices can be simplified.

According to a variant of the invention, the step of attaching the transducer element to the substrate can comprise a step of soldering the sealing structure and the electrical connection structure. Thus, using conventional soldering techniques, the sealing of a media channel is realized together with the electrical connections.

According to a variant, the method can further comprise before step c): a step of providing an integrated snubber structure inside the wafer in the sensitive area of the transducer element. Providing integrating snubber structures inside the wafer, allows reducing the size of the transducer element and improves the integration into a complete pressure sensor.

According to another variant, the method can further comprise before step c) a step of providing a groove in the wafer around the sensitive area of the transducer element in the wafer, the groove being in particular realized such that after step b) the groove is positioned between the sensitive area of the transducer element and both the sealing structure and the electrical connections. Thus, for a plurality of transducer elements, vibration isolation features to protect the sensitive region can be provided on wafer level.

According to a variant of the invention, the method can further comprise before step c) a step of providing a channel in the wafer, said channel being at least partially aligned with the sensitive region of the transducer element. The method provides a plurality of transducer elements on wafer level with a channel for a measurand. With such a transducer further integrated pressure sensors can be realized and/or differential pressure sensors having media channels on both sides of the measuring membrane can be realized.

The object of the invention is also achieved with a microelectromechanical transducer element configured to be mount on a substrate with electrical circuitry and electrical components to form a MEMs sensor arrangement, the microelectromechanical transducer element comprising: a sensitive region with a membrane and one or more sensing elements over a transducer substrate for monitoring at least one measurand and generating an electrical signal correlated with the at least one measurand, and one or more electrical contacts for outputting the electrical signal, and a sealing structure and an electrical connections made out of the same material, in particular provided on the same surface of the transducer element, in a state before being mount onto the substrate. The transducer element according to the invention allows simplifying the integration process of the transducer element on a substrate with further circuitry and electrical components to form a pressure sensor. The presence of the sealing structure and electrical connections already on the transducer element remove integration complexity for the client of an OEM providing the transducer.

According to a variant of the invention, a solder material can realize the sealing structure and the electrical connection structure, in particular a reflow solder material. The use of a solderable material as a sealing means for sealing sensitive regions, including the electrical or electronic components against the ingress of humidity and aggressive chemicals that can be put in place in one step with assembling other solder connections like the electric connection between the transducer element and other elements necessary for realizing a sensor arrangement.

According to a variant of the invention, the transducer element can further comprise one or more vias in the wafer transducer substrate of the transducer element each one connecting one of the electrical contacts with one of the electrical connections. Using vias the electrical contacts and electrical connections can be provided on opposite surface sides of the transducer substrate. Thus, if needed, a further improved protection of the electrical connections at the transducer element level can be provided.

According to a variant of the invention, the microelectromechanical transducer element can further comprise a channel within the transducer substrate, said channel being in fluidic connection with the membrane of the sensitive region. The transducer element comprising a channel in the wafer/substrate it becomes possible to further reduce the size of the sensor and/or to configure it as a differential pressure sensor.

According to a variant, the channel can be realized as a snubber structure. Snubber structures protect pressure sensors against transient events of high pressure, e.g. pressure spikes, which can cause damage of the membrane when the pressure peak leads to a membrane deformation beyond its predetermined yield point. Realizing an integrated snubber structures in the substrate further reduces the size of the sensor.

According to a variant, the microelectromechanical transducer element can further comprise a groove provided in the transducer substrate and positioned between the sensitive area of the transducer element and both the sealing structure and the electrical connections. Such a groove serves as a stress release structure and protects the sensitive region of the transducer against outside vibrations. Accordingly, the transducer element presents a more reliable functioning, while providing a compacter design.

The object of the invention is also achieved with a microelectromechanical sensor arrangement comprising:
- a microelectromechanical transducer element comprising a sensitive region with a membrane and one or more sensing elements over a transducer substrate for monitoring at least one measurand and generating an electrical signal correlated with the at least one measurand, and one or more electrical contacts for outputting the electrical signal,
- a substrate comprising at least one media channel there through,
wherein the microelectromechanical transducer element is mount on the substrate such that the media channel is in fluidic connection with the membrane of the sensitive region of the transducer element, and wherein a sealing structure is surrounding the channel is sandwiched between the transducer element and the substrate and electrical connections are sandwiched between the transducer element and the substrate to electrically connecting the transducer element and the substrate, wherein the sealing structure and the electrical connection structure are made out of the same material. With this sensor all advantages already described above can be achieved.

The invention may be understood by reference to the following description taken in conjunction with the accompanying figures, in which reference numerals identify features of the invention.
Figure 1 illustrates a schematic side cut view of a microelectromechanical (MEMS) sensor system according to the state of the art.
Figure 2a illustrates a schematic view of a fabrication method of a microelectromechanical transducer element according to a first embodiment of the invention.
Figure 2b illustrates a side view of a microelectromechanical transducer element according to a variant of the first embodiment of the invention.
Figure 2c illustrates a top view of the microelectromechanical transducer element obtained with the fabrication method according to the first embodiment of the invention.
Figure 2d illustrates a schematic view of a fabrication method of a microelectromechanical sensor arrangement according to a variant of the first embodiment of the invention.
Figure 2e illustrates a schematic view of a fabrication method of a microelectromechanical sensor arrangement according to a second variant of the first embodiment of the invention.
Figure 2f illustrates a schematic view of a fabrication method of a microelectromechanical sensor arrangement according to a third variant of the first embodiment of the invention.
Figure 3a illustrates a schematic view of a fabrication method of a microelectromechanical transducer element according to a second embodiment of the invention.
Figure 3b illustrates a schematic view of a microelectromechanical sensor arrangement according to a variant of the second embodiment of the invention.
Figure 3c illustrates a schematic view of a microelectromechanical sensor arrangement according to a second variant of the second embodiment of the invention.
Figure 4a illustrates a schematic view of a fabrication method of a microelectromechanical transducer element according to a third embodiment of the invention.
Figure 4b illustrates a schematic view of a fabrication method of a microelectromechanical sensor arrangement according to a variant of the third embodiment of the invention.
Figure 5a illustrates a schematic view of a fabrication method of microelectromechanical transducer element fabricated according to a fourth embodiment of the invention.
Figure 5b illustrates a schematic view of a microelectromechanical sensor arrangement according to a variant of the fourth embodiment of the invention.
Figure 6a illustrates a schematic view of a fabrication method of microelectromechanical transducer element fabricated according to a fifth embodiment of the invention.
Figure 6b illustrates a schematic view of a microelectromechanical sensor arrangement according to a variant of the fifth embodiment of the invention.
Figure 7a illustrates a schematic view of a transducer element fabricated according to a sixth embodiment of the invention.
Figure 7b illustrates a schematic view of a microelectromechanical sensor arrangement according to a variant of the sixth embodiment of the invention.
Figure 8a illustrates a schematic view of a transducer element fabricated according to a seventh embodiment of the invention.
Figure 8b illustrates a schematic view of a microelectromechanical sensor arrangement fabricated according to a variant of the seventh embodiment of the invention.
Figure 8c illustrates a schematic view of a microelectromechanical sensor arrangement fabricated according to a second variant of the seventh embodiment of the invention.
Figure 8d illustrates a schematic view of a microelectromechanical sensor arrangement fabricated according to a third variant of the seventh embodiment of the invention.
Figure 9 illustrates a schematic view of a microelectromechanical sensor system according to an eighth embodiment of the invention.

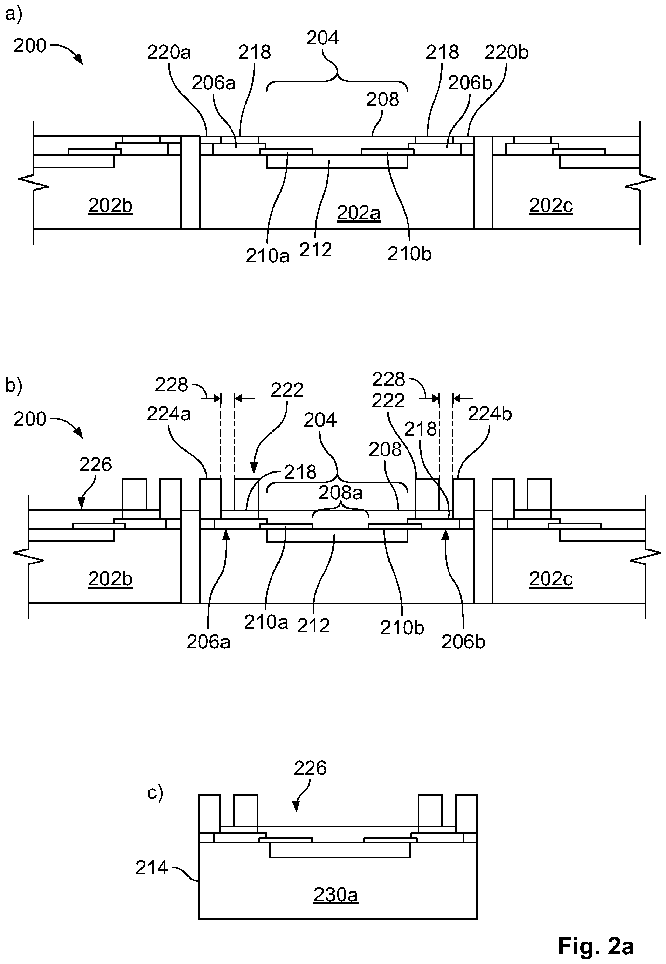

Figure 2a shows a schematic diagram of a method of fabrication of a plurality of individual microelectromechanical transducer elements according to a first embodiment of the invention.

The method comprises a step a) of realizing a plurality of individual transducer elements 202a, 202b, 202c on a wafer 200, e.g. a silicon wafer, using a microelectromechanical device fabrication process as known in the art.

The individual microelectromechanical transducer elements 202a, 202b, 202c of the plurality of microelectromechanical transducer elements all have the same structural features. Here, only transducer element 202a will be described in detail, transducer elements 202b, 202c like all other transducer elements on the wafer 200 are realized in the same way.

The transducer element 202a comprises a sensitive region 204 for monitoring at least one measurand and generating an electrical signal correlated with the at least one measurand, and one or more electrical contacts 206a, 206b for outputting the electrical signal.

The sensitive region 204 comprises a membrane 208, also called diaphragm, carrying a plurality of sensing elements 210a, 210b electrically connected to the one or more electrical contacts 206a, 206b. The membrane 208 of the sensitive region 204 is provided above a cavity 212 in the wafer 200. In the embodiment illustrated, the sensing elements 210a, 210b are facing the inner cavity 212. In an alternative, they could be provided on the other side of the membrane 208 thus facing away from the cavity 212. The sensing elements 210a, 210b can be strain gauges or capacitive structures.

In this embodiment, the sensing elements 210a, 210b are provided between the membrane 208 and the inner cavity 212. In an alternative, the sensing elements 210a, 210b can also be provided above the membrane 208, on the surface 226 of the wafer.

The electrical contacts 206a, 206b are electrically connected with the sensing elements 210a, 210b respectively.

An insulating or non-conductive layer 218 is deposited at least partially over the electrical contacts 206a, 206b respectively. A portion 220a, 220b of the electrical contacts 206a, 206b remains uncovered.

According to the invention, the method then comprises a step b) of providing, for each microelectromechanical transducer element 202a, 202b, 202c a sealing structure 222 around its sensitive region 204 and electrical connections 224a, 224b electrically connected respectively to the electrical contacts 206a, 206b.

According to the invention the sealing structure 222 and the electrical connections 224a and 224b are made out of the same material, in particular a solder material, more in particular a reflow solder material. Thus, the sealing structure 222 and the electrical connections 224a, 224b can be realized during the same process step. To realize the sealing structure 222 and the electrical connections 224a, 224b, a layer of a solder material is deposited on the wafer 200 and then patterned e.g. using screen printing or photolithography techniques known in the art. Alternatively, bumping or electrolytic metal deposition techniques can be used as well.

In this embodiment, the sealing structure 222 and the electrical connections 224a, 224b are provided on the same surface side 226 of the wafer 200, namely the side with the membrane 208 of the transducer elements 202a, 202b, 202c.

The sealing structure 222 and the electrical connection structure 224a, 224b are separated by a gap 228 to be electrically isolated from each other.

The sealing structure 222 is provided at least partially over the insulating layer 218 to be electrically isolated from the electrical contacts 206a, 206b of the transducer element 202a.

In contrast thereto, the electrical connections 224a, 224b are arranged at least partially on the free portion 220a, 220b of the electrical contacts 206a, 206b to realize an electrical contact with the electrical contacts 206a, 206b.

The sealing structure 222 is realized such that it surrounds the active region 204 of the membrane 208

Then, according to step c) of the inventive method, the wafer 200 is diced to form individual microelectromechanical transducer elements. Here only the individual transducer element 230a is illustrated. In the following a wafer 200 that has been diced, will be called transducer substrate 214.

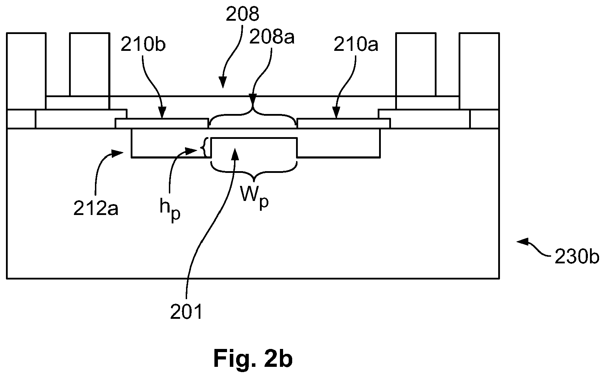

Figure 2b illustrates a transducer element 230b according to a variant. The only difference with respect to the transducer element 230a of Figure 2a is a different shape of the cavity 212a. In this variant, a protrusion 201 remains after realizing the cavity 212a in the wafer 200.

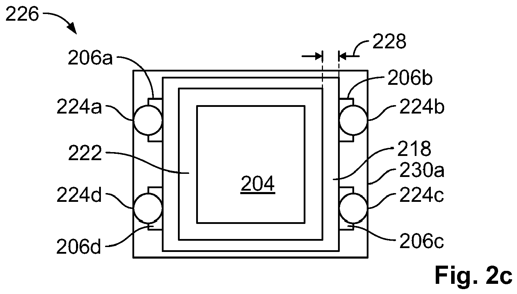

The protrusion extends into the cavity 212a towards the membrane 208. The protrusion 201 can have varying heights hₚ and widths wₚ. Typically wₚ is less than the distance 208a between the sensing elements 210a, 210b. The protrusion 201 allows limiting the extend of the flexure of the membrane 208. Figure 2c is a schematic view onto the active surface side 226 of the transducer element 230a. As illustrated, the sealing structure 222 surrounds the sensitive region 204 of the transducer element 230a. The sealing structure 222 in this embodiment has a square-shape. However, other forms, like a ring shape, could be used as long as the sealing structure 222 surrounds the sensitive region 204.

The electrical connections 224a, 224b, 224c 224d are positioned on the electrical contacts 206a, 206b, 206c, 206d spaced apart by a gap 228 from the sealing structure 222 via the insulating layer 218.

In Figure 2c, four electrical connections 224a, 224b, 224c and 224d on four electrical contacts 206a, 206b, 206c, 206d are illustrated. However, more or less connection structures and electrical contacts of different shape and size may be used depending on the requirements and the number of sensing elements used.

According to the invention, the individual microelectromechanical transducer element 230a comprises a sealing structure 222 and electrical connections 224a, 224b, 224c and 224d on the active surface side 226 made of the same material and realized already during the MEMS level process steps at the OEM prior to dicing and not on packaging level at the customer site. This simplifies the integration of the transducer element 230a at the customer site.

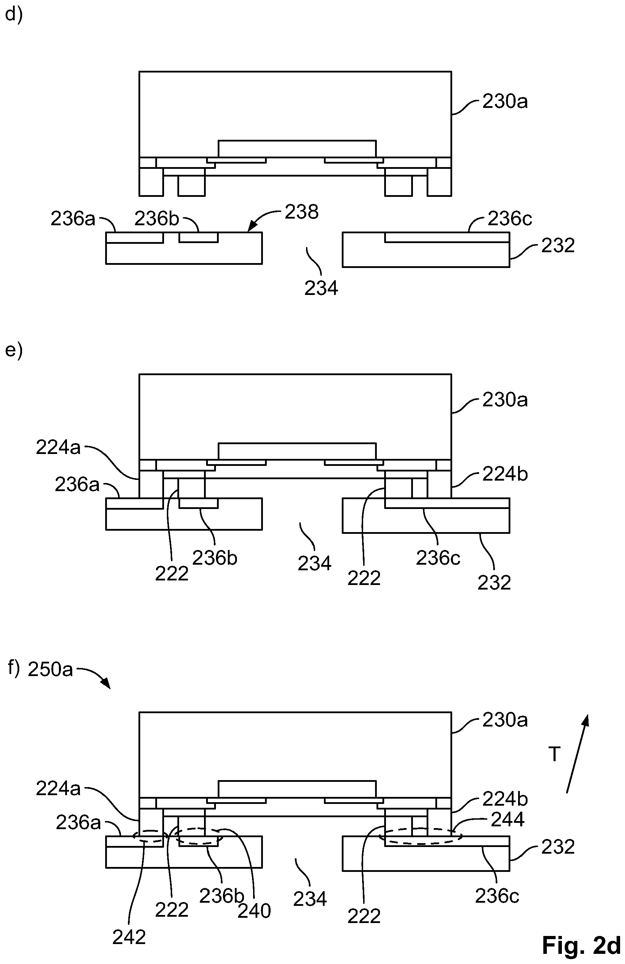

According to a first variant of the embodiment according the invention illustrated in figure 2d, the manufacturing process continues after step c) with a step d) of providing a transducer element 230a and a substrate 232, e.g. at a customer site. The substrate 232 can be chip carrier, in particular a ceramic chip carrier, a PCB, a flexible circuit board, a leadframe or the like.

The substrate 232 comprises at least one media channel 234 that extends through the substrate 232. The substrate 232 comprises further contact pads 236a, 236b, 236c provided on a surface 238 of the substrate 232. The contact pads 236a, 236b, 236c are made of a conductive material, in particular metal.

In the subsequent step e), the transducer element 230a is positioned on the substrate 232. Here, the electrical connection 224a is aligned with the contact pad 236a and the sealing structure 222 is aligned with the contact pad 236b on the one side of the channel 234 of the substrate 232. On the other side of the channel 234, the sealing structure 222 and the electrical connection 224b are aligned with the contact pad 236c.

Subsequently, a soldering step is realized, illustrated by step f), to thereby seal the media channel 234 from the electrical connections 224a and 224b with the sealing structure 222. At the same time, the transducer element 230a is electrically connected to the substrate 232 via the electrical connections 224a and 224b.

The soldering in step f) may be performed by a reflow soldering technique during which the substrate 232 and the transducer element 230a are heated beyond the fusion point of the solder material used for the sealing structure 222 and the electrical connection structures 224a, 224b. After cooling down, reliable solder connections 240, 242, 244 are established between the substrate 232 and the transducer element 230a, in particular between the contact pad 236a, 236b, 236c of the substrate 232 and the sealing structure 222 and the electrical connection structures 224a, 224b of the transducer elements 230a.

After step f) a MEMs sensor arrangement 250a is obtained that realizes reliable electrical contacts and a reliable protection of the parts of the sensor that are outside the media channel 234.

As shown in step f) of Figure 2d, the solder connection 240 for sealing between the contact pads 236b and the sealing structure 222 is separated from the solder electrical connection 242 between the contact pad 236a and the electrical connection structure 224a. To the contrary, the solder connection 244 electrically connects the sealing structure 222 and the electrical connection structure 224a via the contact pad 236c. According to an alternative, the sealing structure 222 may be electrically isolated from all sensing elements 210a, 210b, but connected to ground using an additional contact pad on the substrate 232.The formed solder connections 240, 242, 244 form the electrical connections as well as provide a secure sealing against the ingress of humidity and/or aggressive chemicals coming from the media channel 234 into the interface between the transducer element 230a and the substrate 232.

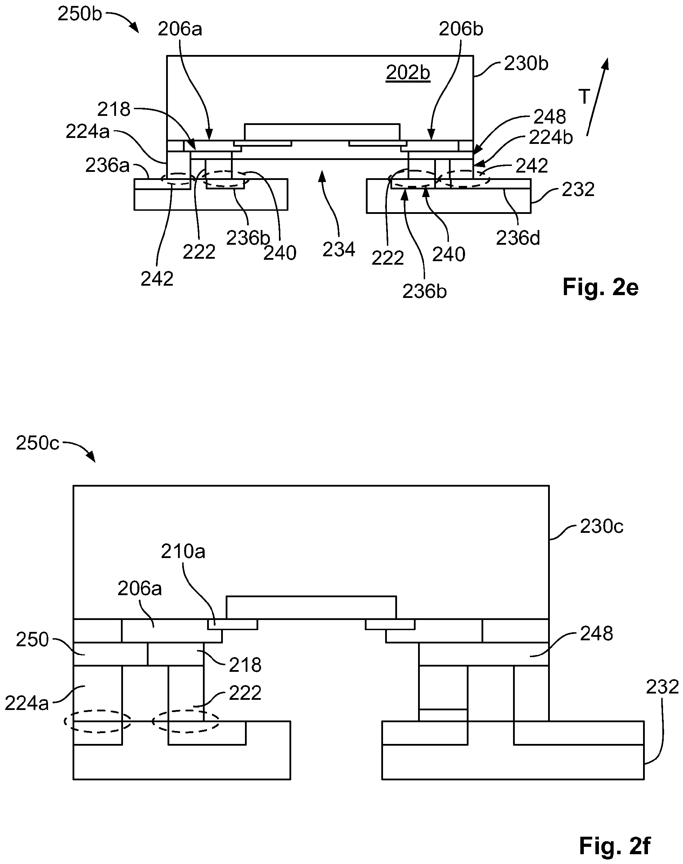

A second variant of the invention is shown in Figure 2e illustrating a MEMs sensor arrangement 250b comprising a transducer element 230b connected to a substrate 232. The only difference between this variant and the transducer element 230a and MEMs sensor arrangement 250a, illustrated in Figure 2d is a different electrical connection between the sealing structure 222 and the electrical connection 224b. All other features remain the same and reference made is to the description above.

Instead of realizing the electrical connection between the sealing structure 222 and the electrical connection 224b on the substrate 232 side using contact pad 236c as shown in Figure 2d, the electrical connection is realized on the transducer element 202b side using an electrically conductive layer 248.

The electrically conductive layer 248 also electrically connects the electrical contact 206b with the electrical connection 224b. The insulating layer 218 remains present between the electrical contact 206a and the sealing structure 222.

The solder connection 240 with the substrate 232 is then realized between the sealing structure 222 and contact pad 236b and the solder electrical connection 242 is realized between the electrical connection structure 224a and the contact pad 236a and the electrical connection structure 224b and an additional contact pad 236d.

The electrically conductive layer 248 allowing the electrical connection between the sealing structure 222 and the electrical connection 224b can be provided at least partially around the media channel 234 or even extend entirely around it. In this case, the isolating layer 218 is arranged such that an electrical isolation between the sealing structure 222 and the other electrical connections 224a, 224c and 224d are guaranteed.

A third variant of the invention is shown in Figure 2f illustrating a MEMs sensor arrangement 250c comprising a transducer element 230c connected to a substrate 232. The only difference between this variant and the transducer element 230b and MEMs sensor arrangement 250b illustrated in Figures 2e is a different electrical connection between the electrical connection 224a and the electrical contact pad 206a of the sensing element 210a. All other features remain the same and reference is made is to the description above.

In this variant, the electrical connection structure 224a is not directly connected to the electrical contact 206a like in the other embodiments but via an electrically conductive layer 250, which can be realized at the same time as the electric conductive layer 248. Like in the other embodiments, the electrical connection structure 224a is electrically isolated from the sealing structure 222 using the insulating layer 218.

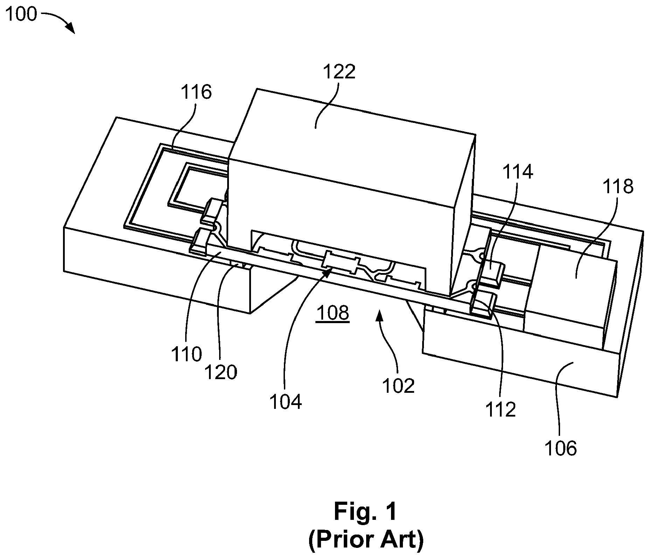

In use, a measurand from a measurement volume enters the MEMs sensor arrangement 250a or 250b via the media channel 234. The membrane 208 of the transducer element 230a deforms under the pressure difference between the measurand and the pressure in the cavity 212. The deformation or stress is sensed by the sensing elements 210a and 210 and electrical signals proportional to the pressure are output via the contact pads 236a and 236b to be treated in the further electrical components, like components 118 shown in Figure 1.

Using the same solderable material as sealing structure and as electrical connection structure allows realizing the sealing and the electrical connection step of the transducer element with the substrate during the same manufacturing step at the transducer element level. Thus, the assembly process can be shortened and facilitated.

In addition, by providing the electrical connections 224a, 224b below the membrane 208, it is no longer necessary to provide electrical contacts 112 on the side of the like in the prior art as shown in the art. This allows reducing the size of the final transducer element 230a.

In a third variant of the embodiment, not shown, the steps d), e) and f) are performed before step c) of dicing the wafer 200. In this variant, a substrate is provided that comprises a plurality of channels corresponding to the number of transducer elements present on the wafer.

For the following embodiments of the invention and their variants and alternatives, the features in common with the first embodiment and its variants and alternatives will not be described in detail again, but reference is made to their description above and the same reference numbers will be used.

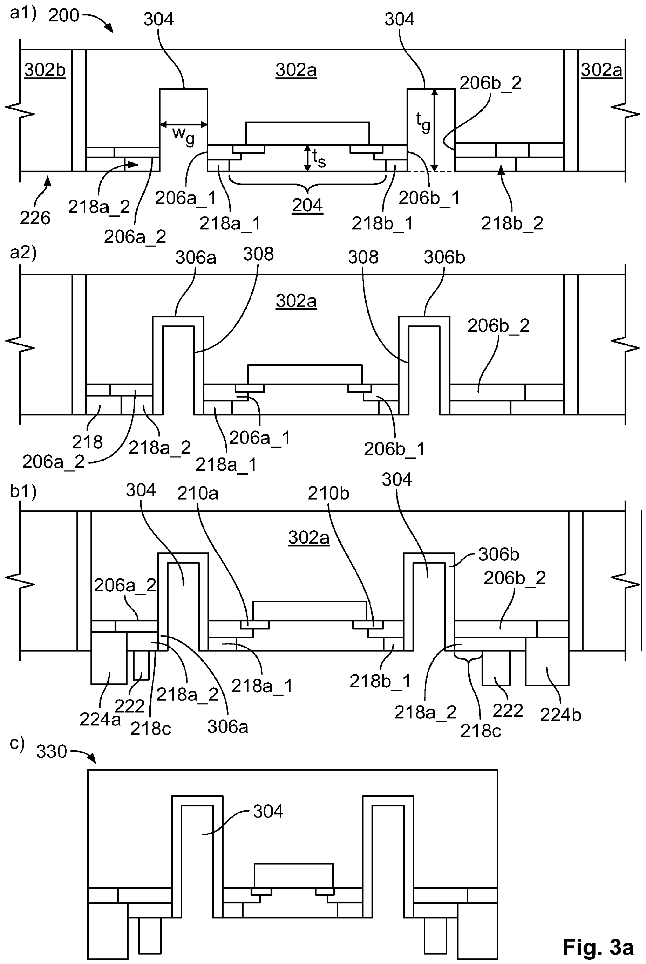

Figure 3a illustrates a fabrication method of a MEMS transducer element according to a second embodiment of the invention.

In this embodiment, the step a) of realizing a plurality of microelectromechanical transducer elements 302a, 302b, 302c on a wafer 200 comprises the additional patterning process step a1) of realizing a groove 304 preferably for each transducer element 302a of the plurality of transducer elements realized on the wafer 200. All the other features of the transducer element 302a are the same as the features of the transducer element 202a described in the first embodiment, and reference is made to their description in the first embodiment. Where applicable, the same reference numbers will be used.

Step a1) is realized before step b). The groove 304 is realized around the sensitive region 204 of the transducer element 302a, on the active surface side 226 of the transducer element 302a. The minimum width *w_{g}* of the groove 304 is set by the limits of the manufacturing process, and can typically range from 10 µm to 400 µm. The minimum depth *t_{g}* of the groove 304 is preferably deeper than the thickness *tₛ* of the sensitive region 204. A groove 304 having a depth larger than the thickness *tₛ* of the sensitive region 204 will provide better stress isolation. The groove 304 separates the electrical contacts 206a, 206b in two parts 206a_1 and 206a_2, 206b_1 and 206b_2, one part on each side of the groove 304. The groove 304 also separates the insulating layer 218 in two parts 218a_1 and 218a_2, 218b_1 and 218b-2, one on each side of the grove 304.

To maintain the electrical connection between the two parts of the electrical contacts 206a_1 and 206a_2, 206b_1 and 206b_2, respective electrically conductive layers 306a and 306b are deposited on the side walls 308 of the groove 304 during step a2) as illustrated in Figure 3a. The electrically conductive layers 306a, 306b can be metallic layers, e.g. an aluminum or copper layer. The electrically conductive layers 304, 306b are partially deposited within the groove 304 in order to avoid creating an electrical short circuit between the electrical contact pads 206a, 206b, 206c, 206d of the transducer element 302a. The electrically conductive layer 304a, 306b is deposited within the groove 304 so as to provide an electrical connection with the electrical contact pads 206a_1, 206b_1 locally.

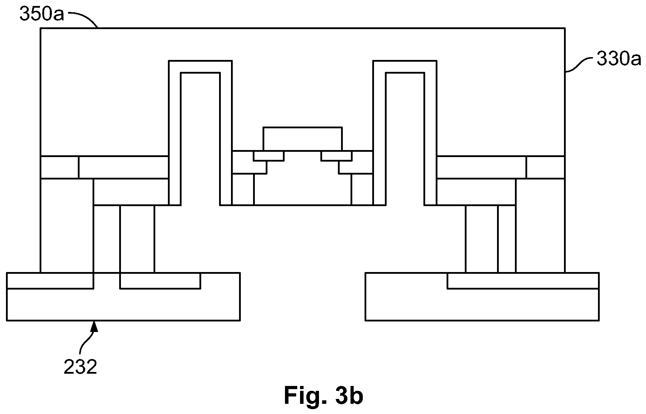

For this embodiment, the steps b) and c) are realized in the same way as in the first embodiment and its variants and alternatives. However, as illustrated in step b1) of Figure 3b, the sealing structure 222 is arranged around the sensitive region 204 on the outer side of the groove 304. Thus, both the sealing structure 222 and the electrical connections 224a, 224b on the electrical contacts 206a_2 and 206b_2 are arranged on the outer side of the groove 304. Indeed, since both the sealing structure 222 and the electrical connections 204 can negatively affect the transducer element 302a, the groove 304 is positioned so as to decouple both areas. The groove 304 is positioned between the sensitive area 204 of the transducer element 302a and both the sealing structure 222 and the electrical connections 224a, 224b, in order for the groove 304 to serve as an outside stress decoupling feature to reduce the influence of external stress onto the sensing elements 210a, 210b. The groove 304 therefore leads to a more reliable transducer element with a reduced sensibility to outside vibrations at the transducer element level.

Furthermore, the sealing structure 222 is deposited on the insulating layer 218a_2, 218b_2 and spaced apart from the electrically conductive layer 306a, 30b, such that a portion 218c of the insulating layer 218a_2, 218b_2 is not covered by the sealing structure 222. Thus, an electrical contact between the sealing structure 222 and the electrically conductive layer 306a, 306b of the groove 304 can be prevented.

In this embodiment, the electrically conductive layer 306a, 306b, the sealing structure 222 and the electrical contact 224a, 224b can be made of the same material.

In addition, since the groove 304 is integrated into the wafer 200, the transducer element 302a offers a compact design.

Thus, after step c), a transducer element 330a is obtained having all the features of the transducer element 230a of the first embodiment but in addition, the stress decoupling feature in the form of the groove 304.

Figure 3b illustrates the transducer element 330a soldered to substrate 232 to obtain a MEMs sensor arrangement 350a according to a first variant of the second embodiment. The process steps to obtain the MEMS sensor arrangement 350a correspond to the steps d) to f) of the first variant of embodiment 1.

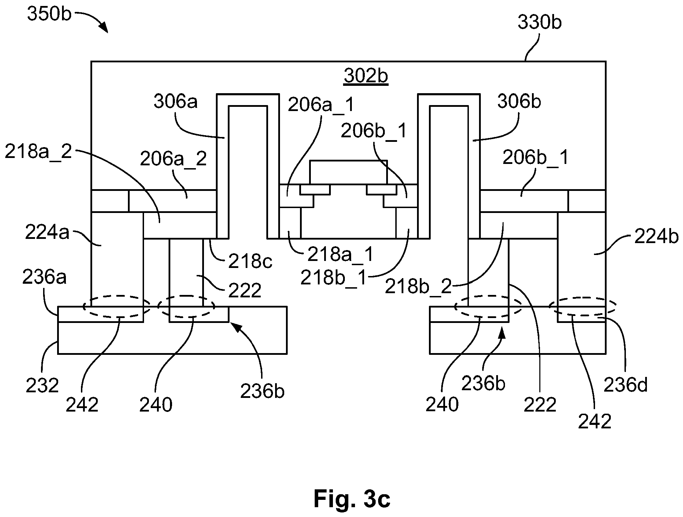

A second variant is shown in Figure 3c illustrating a MEMs sensor arrangement 350b comprising a transducer element 330b connected to a substrate 232. The only difference between this variant and the transducer element 330a and MEMs sensor arrangement 350a, illustrated in Figure 3b is a different electrical connection between the sealing structure 222 and the electrical connection 224b and between the electrical connection 224a and the electrical contact 206a_2. All other features remain the same and reference made is to the description above.

Instead of realizing the electrical connection between the sealing structure 222 and the electrical connection 224b on the substrate 232 side using the contact pad 236c as shown in Figure 2d, the electrical connection is realized on the transducer element 302b side using the electrically conductive layer 306b present within the groove 304.

In this variant, the sealing structure 222 is deposited on top of the insulating layer 218b_2 but in contact with the electrically conductive layer 306b, and thus is also electrically connected with the electrical contact 206b_2 and with the electrical connection 224b. The insulating layer 218b_2 remains, however, present between the electrical contact 206b_2 and the sealing structure 222. According to a variant, a layer 218 could be present like in Figure 2f.

The solder connection 240 with the substrate 232 is then realized between the sealing structure 222 and contact pad 236b and the solder electrical connection 242 between the electrical connection structure 224a and the contact pad 236a and the electrical connection structure 224b and an additional contact pad 236d. The solder connection 240 extends around the media channel 234.

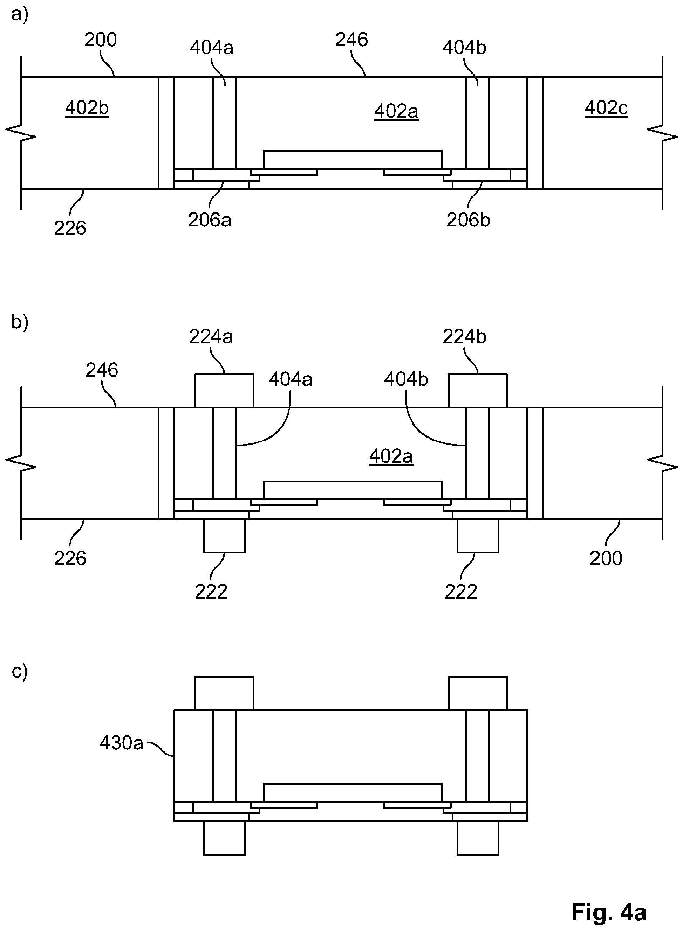

Figure 4a illustrates a fabrication method of a MEMS transducer element according to a third embodiment of the invention.

In this embodiment, the step a) of realizing a plurality of microelectromechanical transducer elements on a wafer 200 comprises additional process steps of providing vias 404a, 404b, e.g. so called through silicon vias (TSV), through the wafer 200 of the transducer element 402a, 402b, 402c.

First corresponding through holes are realized through the wafer 200 which are then filled with an electrically conductive material, in particular metal. All the other features of the transducer element 402a are the same as the features of the transducer element 202a described in the first embodiment, and reference is made to their description in the first embodiment. In addition, the same reference numbers are used where appropriate.

The vias 404a, 404b are positioned such as to allow an electrical connection with the electrical contacts 206a, 206b on the opposite surface side 246, opposite to the active surface side 226.

During step b) of this embodiment, the electrical connections 224a, 224b and the sealing structure 222 are then realized on opposite surface sides of the wafer 200, i.e. of the transducer element 402a.

As shown in step b) of Figure 4a, the sealing structure 222 is provided on the surface side 226 of the transducer element 202a where the sensitive region 204, i.e. the membrane 208, is provided.

The electrical connection structures 224a, 224b are provided on the opposite side 246 of the active surface side 226 of the transducer element 202a, in direct contact with the vias 404a, 404b respectively.

After dicing, as shown in step c), an individual transducer element 430a is obtained.

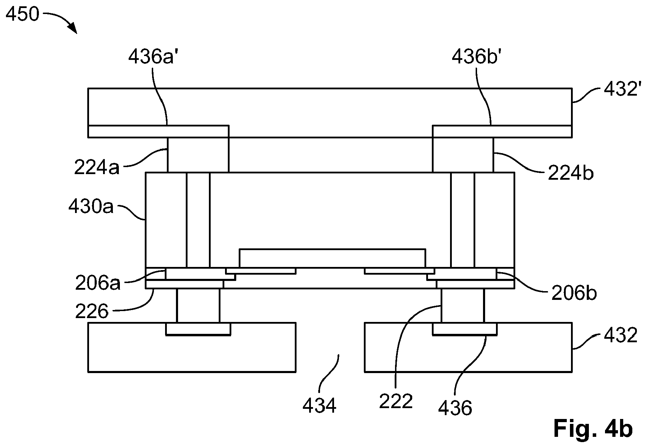

This transducer element 430a can then be mount to two different substrates 432 and 432' as illustrated in Figure 4b, to realize a MEMs sensor arrangement 450 according to a variant of the third embodiment.

The transducer element 430a is mount on its active surface side 226 to a substrate 432 using the sealing structure 222. Furthermore, the transducer element 430 is mount to the substrate 432' using the electrical connections 224a, 224b on its other surface side 246. The transducer element 430a is thus sandwiched between two substrates 432, 432'.

The substrate 432 comprises a media channel 434, like substrate 232 and electrical conductive pad 436 so that the sealing structure 222 can be attached using soldering like in the first and second embodiment.

The second substrate 432' comprises electrical conductive pads 436a, 436b to realise the electrical connections with the electrical contacts 206a and 206b.

By arranging, the sealing on the one side and the electrical connections on the other side a more compact design can be realized and, in addition, the electrical components can be arranged further away from the media channel.

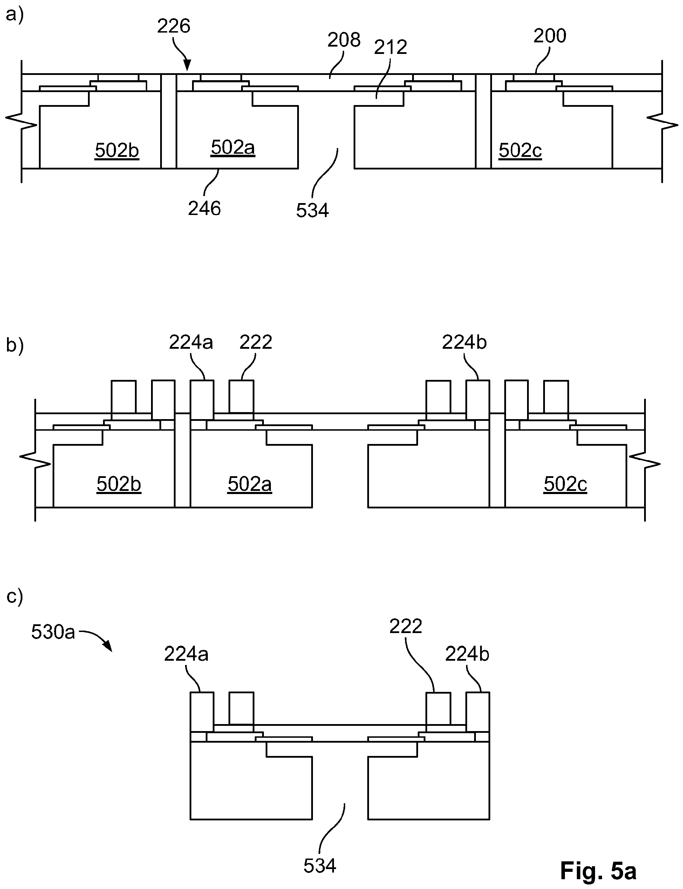

Figure 5a illustrates a schematic view of a fabrication method of microelectromechanical (MEMs) transducer elements 502a, 502b, 502c fabricated according to a fourth embodiment of the invention.

In this embodiment, an additional process step is realized during step a) to provide a media channel 534 for each transducer element 502a, 502b, 502c in the wafer 200. The media channel 534 is realized such that it extends from the opposite surface side 246 with respect to the active surface side 226 up until the cavity 212 and the membrane 208. All the other features of the transducer element 502a are the same as the features of the transducer element 202a described in the first embodiment, and reference is made to their description in the first embodiment. In addition, the same reference numbers are used where appropriate.

Otherwise, the transducer element 502a is realized using the same process steps as described above concerning the first embodiment. Thus, during step b) of this embodiment, the electrical connections 224a, 224b and the sealing structure 222 are realized on the transducer elements 502a, 502b, 502c and after dicing of step c) an individual transducer element 530a with a media channel 534, the electrical connections 224a, 224b and the sealing structure 222 is obtained.

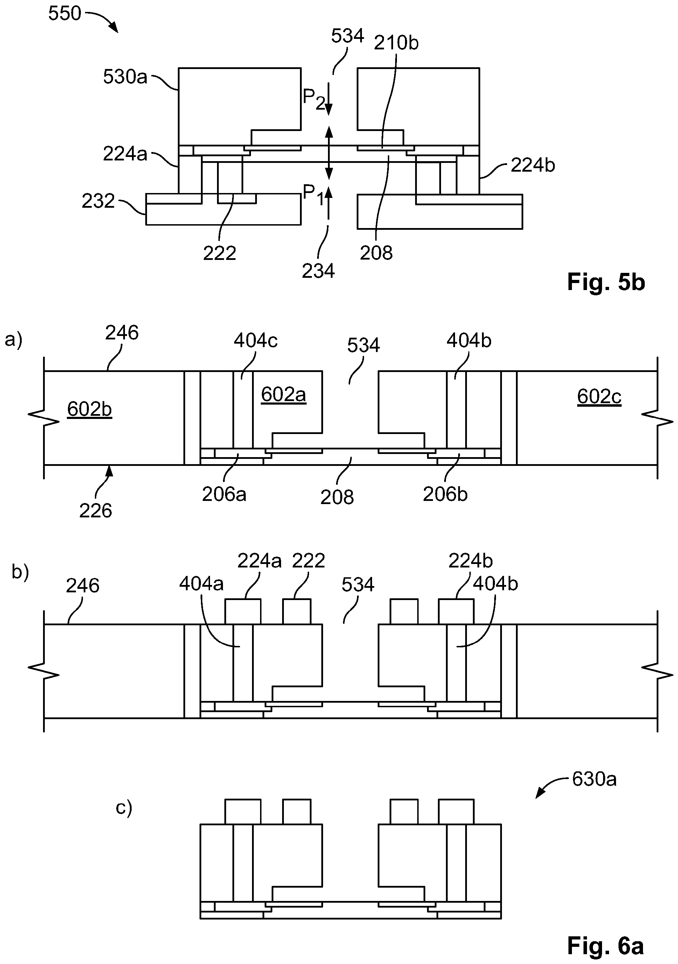

Figure 5b illustrates a schematic view of a microelectromechanical sensor arrangement 550 according to a variant of the fourth embodiment of the invention using the transducer element 530a with the media channel 534 and the substrate 232 with the media channel 234 to realize a differential pressure sensor. Again, the transducer element 530a is attached to the substrate 232 by heating the electrical connections 224a and 224b and the sealing structure 222 above their fusion point.

In this configuration, a first media channel, media channel 234 is provided through which a first media under pressure P1 can impinge on the membrane 208 and a second media channel, media channel 534, is provided through which a second media under pressure P2 can impinge on the membrane 208 from the other side. The sensing elements 210a, 210b detect the displacement or stress of the membrane 208 induced by the pressure difference P1-P2 between media acting on the two sides of the membrane 208, indicated by the double arrow. Thus, a differential pressure measurement can be realized.

Again, according to the invention, the sensor 550 can be integrated using the sealing structure 222 and the electrical connections 224a, 224b already provided at the OEM, thus at wafer level.

Figure 6a illustrates a schematic view of a fabrication method of microelectromechanical transducer element fabricated according to a fifth embodiment of the invention. This embodiment combines the features of the third and fourth embodiment.

In this embodiment, step a) consist in providing a transducer elements 602a, 602b, 602c comprising vias, 404a, 404b connecting the opposite surface side 246 with the electrical contacts 206a and 206 on the membrane 208 on the active surface side 226, like in the third embodiment as shown in Figure 4a, and a media channel 534, as shown in the Figure 5a in the fourth embodiment. The description of the method will therefore not be repeated again but it is referred to the detailed description of the third and fourth embodiment. Furthermore, all the other features of the transducer element 602a are the same as the features of the transducer element 202a described in the first embodiment, and reference is made to their description in the first embodiment. In addition, the same reference numbers are used where appropriate.

The method according to the fifth embodiment then comprises a step b) of providing a sealing structure 222 and electrical connections 224a, 224b on the opposite surface side 246. The electrical connection structures 224a, 224b are provided in direct contact with the vias 404a, 404b respectively like in the third embodiment. The sealing structure 222 is realized to surround the media channel 534.

After dicing, like illustrated by step c), an isolated transducer element 630a is obtained.

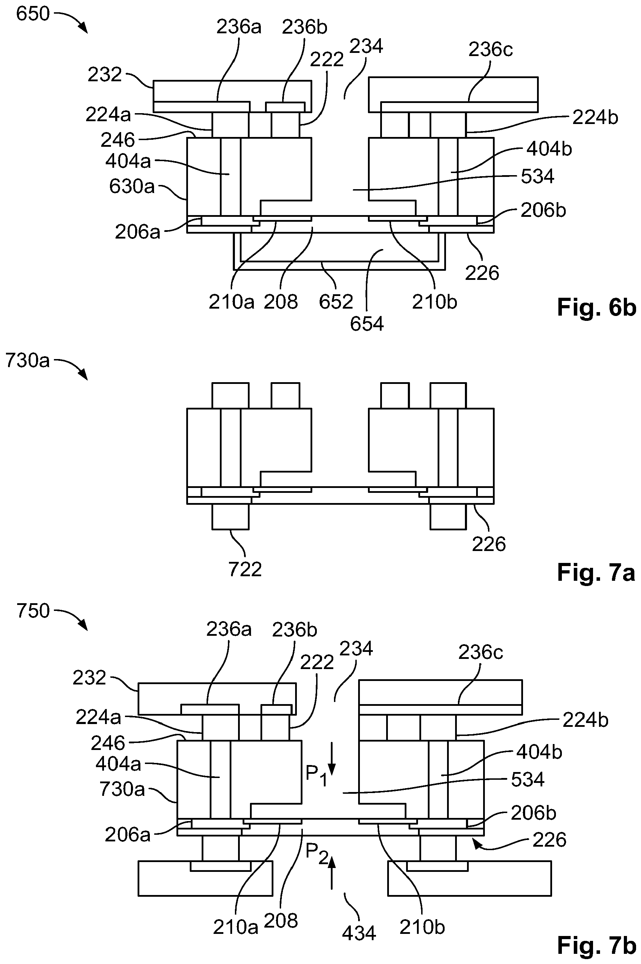

Figure 6b illustrates a schematic view of a microelectromechanical sensor arrangement 650 according to a variant of the fifth embodiment.

In this embodiment, the transducer element 630a is attached with its opposite surface side 246 to a substrate 232 with media channel 234 using process steps d) to f) as illustrated in Figure 2d. The attachment is realized by heating the solder material above its fusion point and cooling down like in the other embodiments.

The soldering step takes place as in the other embodiments between the sealing structure 222, the electrical connection structures 224a, 224b and the electrical contact pads 236a, 236b, 236c of the substrate 232 to form a seal and an electrical connection.

In this embodiment, the seal realised by the sealing structure 222 and the substrate 232 protects the electrical connection structures 224a, 224b from any media in the media channel 234.

The electrical connection structures 224a, 224b provide an electrical connection between the sensing elements 210a, 210b of the membrane 208, in particular the piezoresistive gauge 210a, 210b of the membrane 208, via the electrical contacts 206a, 206b and the vias 404a, 404b with the substrate 232 and other electrical component present in a sensor arrangement.

A cap 652 is provided to realize a reference volume 654 on the active surface side 226 of the membrane 208 of the transducer element 630a.

In this configuration, a pressure sensor is realized in which the media enters via the media channel 234 and the media channel 534 to deform the membrane 208 against the pressure in the reference volume 654.

Figure 7a illustrates a schematic view of a transducer element 730a fabricated according to a sixth embodiment of the invention. The fabrication process to obtain the transducer element 730a according to the sixth embodiment is similar to the one of the fifth embodiment, except that in step b) a second sealing structure 722 is provided on the active surface side 226. Besides that, all features of the transducer element 730a are the same as for the transducer element 630 illustrated in Figure 6a, reference is therefore made to its description above.

The second sealing structure 722 is made of the same material as the sealing structure 222 and is deposited in the same way either before or after the process step of realising structure 222.

Figure 7b illustrates a schematic view of a microelectromechanical sensor arrangement 750 according to a variant of the sixth embodiment.

In this embodiment, like fourth embodiment illustrate in Figure 5b, a differential pressure sensor is realized.

To do so a substrate 232 is attached to the opposite surface side 246 of the transducer element 730a. Attachment is realized by heating the solder material above its fusion point and cooling down like in the other embodiments.

The soldering step takes place as in the other embodiments between the sealing structure 222, the electrical connection structures 224a, 224b and the electrical contact pads 236a, 236b, 236c of the substrate 232 to form a seal and an electrical connection.

In this embodiment, the seal realised by the sealing structure 222 and the substrate 232, protects the electrical connection structures 224a, 224b from any media in the media channel 234 and 534.

The electrical connection structures 224a, 224b provide an electrical connection between the piezoresistive gauge 210a, 210b of the membrane 208 via the electrical contacts 206a, 206b and the vias 404a, 404b with the substrate 232 and other electrical component present in a sensor arrangement.

A second substrate 432, like already used in the third embodiment as illustrated in Figure 4b is attached on the active surface side 226.

The soldering step takes place between the second sealing structure 722 and the conductive pad 436. Thus, a second seal is realised by the sealing structure 722 and the substrate 432 to protect the electrical connection structures 224a, 224b from any media in the second media channel 434.

In this configuration, a first media channel, media channel 234 and 534 is provided through which a first media under pressure P1 can impinge on the membrane 208 and a second media channel, media channel 434, is provided through which a second media under pressure P2 can impinge on the membrane 208 from the other side. The sensing elements 210a, 210b detect the displacement of the membrane 208 induced by the pressure difference P1-P2 between the media acting on the two sides of the membrane 208, indicated by the double arrow. Thus, a differential pressure measurement can be realized like in the variant of the fourth embodiment illustrated in Figure 5b.

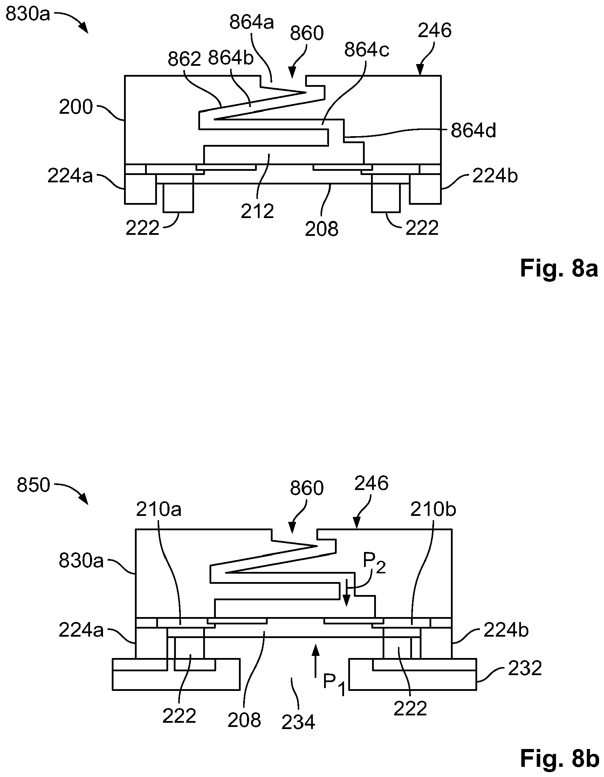

Figure 8a illustrates a schematic view of a fabrication method of microelectromechanical (MEMs) transducer element 830a fabricated according to a seventh embodiment of the invention. This embodiment is similar to the fourth embodiment illustrated in Figures 5a and 5b. The difference between the two embodiments is the use of a snubber structure 860 as media channel instead of the media channel 534 illustrated in Figures 5a and 5b. In pressure sensors, snubber structures are used to mitigate transient events of high pressure, e.g. pressure spikes, which can cause damage of the membrane when the pressure peak leads to a membrane deformation beyond its predetermined yield point, as already known from EP3748325A1, the description of which is incorporated herewith by reference.

Besides the use of a snubber structure 860, all other features are the same as in the fourth embodiment and the transducer element 830a can be realized using the same process steps and is not described in detail again. Instead, reference is made to the detailed description of the fourth embodiment.

Instead of realizing the media channel 534, microelectromechanical production steps as known in the art, for example a succession of dry or wet etching and wafer bonding steps or other alternatives like 3D glass laser structuring, are realized to provide the wafer 200 with an integrated snubber structure 860.

The integrated snubber structure 860 in this embodiment comprises a through channel 862 reaching from the opposite surface side 246 of the transducer element 830a to the cavity 212. The channel 862 comprises two or more portions, in this example four portions 864a, 864b, 864c, 864d, with changing directions to mitigate transient pressure events.

According to the invention, the transducer element 830a of the sixth embodiment furthermore comprises a sealing structure 222 and electrical connections 224a, 224b on the active surface side 226.

Figure 8b illustrates a variant of the sixth embodiment. The transducer element 830a is attached to substrate 232, similar to the variant of the fourth embodiment illustrated in Figure 5b, to form a microelectromechanical sensor arrangement 850 according to a variant of the seventh embodiment of the invention using the transducer element 830a with the snubber structure 860 and the substrate 232 with the media channel 234 to realize a differential pressure sensor. Also in this variant, the transducer element 830a is attached to the substrate 232 by heating the electrical connections 224a and 224b and the sealing structure 222 above their fusion point.

In this configuration, a first media channel, media channel 234 is provided through which a first media under pressure P1 can impinge on the membrane 208 and a second media channel, snubber structure 860, is provided through which a second media under pressure P2 can impinge on the membrane 208 from the other side. The sensing elements 210a, 210b detect the displacement of the membrane 208 induced by the pressure difference P1-P2 between media acting on the two sides of the membrane 208, indicated by the double arrow. Thus, a differential pressure measurement can be realized.

According to the invention, the sensor 850 can be integrated at the site of an OEM, thus already at wafer level, by using the sealing structure 222 and the electrical connections 224a, 224b.

According to further variants, the transducer element 830a and the Mems sensor arrangement 850 could be combined with features of the other embodiment. E.g. vias 404a, 404b could be used to provide the electrical contact on the opposite side surface 246. Furthermore, instead of realizing a differential pressure sensor, a pressure sensor having only one media channel, the snubber structure 860, and using a cap 652 as illustrated in the variant of the fifth embodiment of Figure 6b, could be realized.

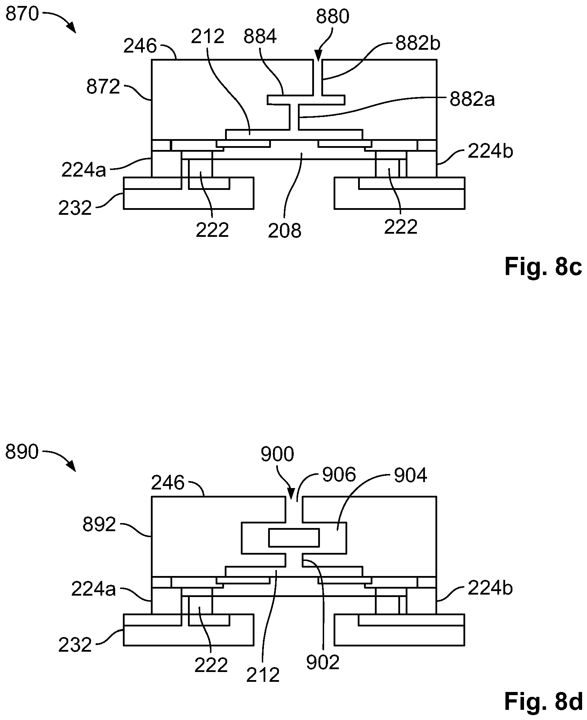

A second variant of a Mems sensor arrangement 870 according to the seventh embodiment comprises a transducer element 872 with an integrated snubber structure 880 attached to a substrate 232 as illustrated in Figure 8c. Also in this variant, the transducer element 872 is attached to the substrate 232 by heating the electrical connections 224a and 224b and the sealing structure 222 above their fusion point. The same process steps can realize this sensor arrangement 870 as the one illustrated in Figure 8b.

The integrated snubber structure 880 comprises a first channel 882a perpendicular to the cavity 212 behind the membrane 208, followed by a second cavity 884 parallel to the first cavity 212 and a second channel 882b again perpendicular which extends through to the opposite surface side 246.

The sensor arrangement 870 as illustrated in Figure 8c is a differential pressure sensor, as the one illustrated in Figure 8b but could also be realized as a pressure sensor having only one medial channel and a cap like illustrated in the variant of the fifth embodiment of Figure 6b. Furthermore, also in this sensor arrangement 870 vias could be used to move the electrical connections to the opposite surface side 246.

A third variant of a Mems sensor arrangement 890 according to the seventh embodiment comprises a transducer element 892 with an integrated snubber structure 900 attached to a substrate 232 as illustrated in Figure 8d. Also in this variant, the transducer element 892 is attached to the substrate 232 by heating the electrical connections 224a and 224b and the sealing structure 222 above their fusion point. The same process steps as the one illustrated in Figure 8b or 8c can realize this sensor arrangement 890.

The integrated snubber structure 900 comprises a first channel 902 in connection with the cavity 212 and an internal cavity 904. The internal cavity 904 in turn is connected to a second channel 906 that extends through to the opposite surface side 246. A pressure mitigation element 908 is furthermore provided inside the internal cavity 904. This pressure mitigation member 908 is a movable element, like a piston, that is configured and formed from a material that enables it to move within the separate cavity to block the first channel 902 under a pressure spike.

The sensor arrangement 890 as illustrated in Figure 8d is a differential pressure sensor, like the one illustrated in Figure 8b or 8c, but could also be realized as a pressure sensor having only one medial channel and a cap like illustrated in the variant of the fifth embodiment of Figure 6b. Furthermore, also in this sensor arrangement 890 vias could be used to move the electrical connections to the opposite surface side 246.

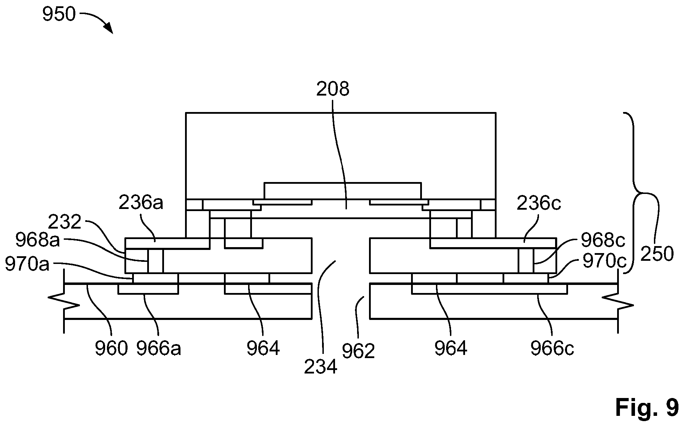

Figure 9 illustrates a schematic view of a microelectromechanical sensor system 950 according to an eight embodiment of the invention.

In this embodiment, a Mems sensor arrangement 250a is mount on a circuit carrier 960. The circuit carrier 960 can be part of a printed circuit board or a flexible board, having further electronic components mounted thereon. According to variants, any one of the Mems sensor arrangements 350a, 350b 450, 550, 650, 750, 870, 850 or 890 according to one of the embodiments two to seven and their variants could be mount instead.

In figure 9, the circuit carrier 960 comprises a media channel 962 aligned with the media channel 234 of the sensor arrangement 250a so that a measurand can impinge on the membrane 208.

A solder seal 964 seals the media channel 962 at the interface between the circuit carrier 960 and the substrate 232 of the MEMs sensor arrangement 250a. The circuit carrier 960 further comprises electrical contact pads 966a and 966c electrically connected with the electrical contact pads 236a and 236c of the substrate 232, e.g. using vias 968a, 968c in the substrate 232 and solder connections 970a and 970c.

Also in this embodiment, the solder seal 964 and the solder connections 970a and 970c can be of the same material, so that the sealing and electrical connections can be realized in one step.

A number of embodiments of the invention have been described. Nevertheless, it is understood that various modifications and enhancements may be made without departing the following claims.

### Reference numerals

- 100: sensor arrangement
- 102: ceramic sensor
- 104: transducer element
- 106: substrate
- 108: media channel
- 110: transducer substrate
- 112: side wall electrodes
- 114: contact pads
- 116: electrical leads
- 118: electrical components
- 120: solder seal
- 122: protective cover

- 200: wafer
- 201: protruding portion of the wafer
- 202a, 202b, 202c: transducer element
- 204: sensitive region
- 206a, 206b, 206c, 206d: electrical contacts
- 206a_1, 206_2, 206b_1, 206b_2,: separated electrical contacts
- 208: membrane
- 208a: distance between sensing elements
- 210a, 210b: sensing elements
- 212: cavity
- 214: transducer substrate
- 218: insulating layer
- 220a, 220b: uncovered portion
- 222: sealing structure
- 224a, 224b, 224c 224d: electrical connections
- 226: active surface side
- 228: gap
- 230a, 230b: transducer element
- 232: substrate
- 234: media channel
- 236a, 236b, 236c, 236d: contact pads
- 238: substrate surface
- 240: solder connection
- 242: solder connection
- 244: solder connection
- 246: opposite surface side
- 248: electrically conductive layer
- 250a, 250b, 250c: Mems sensor arrangement

- 302a, 302b, 302c: transducer element
- 304: groove
- 306a, 306b: conductive layers
- 308: side walls of groove
- 330a, 330b: transducer element
- 350a, 350b: Mems sensor arrangement

- 402a, 402b, 402c: transducer element
- 404a, 404b: vias
- 430a: transducer element
- 432: substrate
- 432': substrate
- 434: media channel
- 436: conductive pad
- 436a', 436b': conductive pads
- 450: Mems sensor arrangement

- 502a, 502b, 502c: transducer element
- 530a: transducer element
- 534: media channel
- 550: Mems sensor arrangement

- 602a, 602b, 602c: transducer element
- 630a: transducer element
- 650: Mems sensor arrangement
- 652: cap
- 654: reference volume

- 722: second sealing structure
- 730a: transducer element
- 750: Mems sensor arrangement

- 830a: transducer element
- 850: Mems sensor arrangement
- 860: snubber structure
- 862: channel of snubber structure
- 864a, 864b, 864c, 864d: portions of different direction in snubber structure
- 870: Mems sensor arrangement
- 880: snubber structure
- 882a: first channel
- 882b: second channel
- 884: second cavity
- 890: Mems sensor arrangement

- 900: snubber structure
- 902: first channel
- 904: internal cavity
- 906: second channel
- 908: pressure mitigation element
- 950: microelectromechanical sensor system
- 960: carrier
- 962: media channel
- 964: seal
- 966a, 966c: contact pads
- 968a, 968c: vias
- 970a, 970c: solder connections

## Claims

1. Method of fabricating a plurality of individual microelectromechanical transducer elements comprising the steps of:
a) realizing a plurality of microelectromechanical transducer elements on a wafer (200), wherein each transducer element comprises a sensitive region (204) with a membrane (208) and one or more sensing elements (210a, 210b), for monitoring at least one measurand and generating an electrical signal correlated with the at least one measurand, and one or more electrical contacts (206a, 206b) for outputting the electrical signal,
b) providing, for each microelectromechanical transducer element, a sealing structure (222) around its sensitive region (204) and one or more electrical connections (224a, 224b) each connected to a respective one of the one or more electrical contacts (206a, 206b), wherein the sealing structure (222) and the electrical connections (224a, 224b) are made out of the same material, in particular a solder material, more in particular a reflow solder material, and then
c) dicing the wafer (200) to form individual microelectromechanical transducer elements.

2. Method according to claim 1, wherein during step b) the sealing structure (222) and the electrical connections (224a, 224b) are realized during the same process steps.

3. Method according to claim 1 or 2, wherein step b) comprises providing the sealing structure (222) and the electrical connections (224a, 224b) over the same surface side of the wafer (200).

4. Method according to claim 1 or 2, wherein the electrical connections (224a, 224b) and the sealing structure (222) are provided over opposite sides of the wafer (200).

5. Method according to any one of claims 1 to 4, further comprising a step of providing at least one via (404a, 404b) per transducer element through the wafer (200).

6. Method according to any one of claims 1 to 5, further comprising before step c):
a step of providing a substrate (232) comprising a plurality of channels (234) extending through the substrate (232),
a step of aligning each channel (234) with a corresponding sensitive region (204) of a micromechanical transducer element, and
a step of attaching the substrate (232) to the wafer (200) using the sealing structure (222) and the electrical connections (224a, 224b) to thereby seal the interface between the sensitive region (204) of the transducer element and the substrate (232) from the remaining region of the transducer element and to electrically connect the one or more electrical contacts (206a, 206b) of the transducer element with mating electrical contacts (236a, 236c) of the substrate (232).

7. Method according to claim 6, wherein the step of attaching the transducer element to the substrate comprises a step of soldering the sealing structure (222) and the electrical connections (224a, 224b).

8. Method according to any one of claims 1 to 7, further comprising before step c) a step of providing an integrated snubber structure (860, 880, 900) inside the wafer (200) in the sensitive area (204) of the transducer element.

9. Method according to any one of claims 1 to 8, further comprising before step c) a step of providing a groove (304) in the wafer (200) around the sensitive area (204) of the transducer element, the groove (304) being in particular realized such that after step b) the groove (304) is positioned between the sensitive region (204) and both the sealing structure (222) and the electrical connections (224a, 224b).

10. Method according to any one of claims 1 to 9, further comprising before step c) a step of providing a channel (534) in the wafer (200), said channel (534) being at least partially aligned with the sensitive region (204) of the transducer element.

11. Microelectromechanical transducer element configured to be mount on a substrate (232) with electrical circuitry and electrical components to form a MEMs sensor arrangement, the microelectromechanical transducer element comprising:
a sensitive region (204) with a membrane (208) and one or more sensing elements (210a, 210b) on a transducer substrate (214) for monitoring at least one measurand and generating an electrical signal correlated with the at least one measurand, and one or more electrical contacts (206a, 206b) for outputting the electrical signal, and
a sealing structure (222) and an electrical connections (224a, 224b) made out of the same material, in particular provided on the same surface of the transducer element in a state before being mount onto the substrate.

12. Microelectromechanical transducer element according to claim 11, wherein the sealing structure (222) and the electrical connections (224a, 224b) are made of a solder material, in particular by a reflow solder material.

13. Microelectromechanical transducer element according to claim 11 or 12, further comprising one or more vias (404a, 404b) provided in the transducer substrate (214) each one connecting one of the electrical contacts (206a, 206b) with one of the electrical connections (224a, 224b).

14. Microelectromechanical transducer element according to any one of the claims 11 to 13, further comprising a channel (536) within the transducer substrate (214), said channel (536) being in fluidic connection with the membrane (208) of the sensitive region (204).

15. Microelectromechanical transducer element according to claim 14, wherein the channel is realized as a snubber structure (860. 880, 900).

16. Microelectromechanical transducer element according to any one of claims 11 to 15, further comprising a groove (304) provided in the transducer substrate (214) and positioned between the sensitive region (203) and both the sealing structure (222) and the electrical connections (224a, 224b).

17. Microelectromechanical sensor arrangement comprising:
- a microelectromechanical transducer element comprising a sensitive region (204) with a membrane (208) and one or more sensing elements (210a, 210b) on a transducer substrate (214) for monitoring at least one measurand and generating an electrical signal correlated with the at least one measurand, and one or more electrical contacts (206a, 206b) for outputting the electrical signal, in particular the microelectromechanical transducer element according to any one of the preceding claims 11 to 16,
- a substrate (232) comprising at least one media channel (234) there through,
wherein the microelectromechanical transducer element is mount on the substrate (232) such that the media channel (234) is in fluidic connection with the membrane (208) of the sensitive region (204) of the transducer element,
wherein a sealing structure (222) is surrounding the channel (234) is sandwiched between the transducer element and the substrate (232) and electrical connections (224a, 224b) are sandwiched between the transducer element and the substrate (234) to electrically connecting the transducer element and the substrate (234), wherein the sealing structure (222) and the electrical connection structure (224a, 224b) are made out of the same material.
